# EUROPEAN PATENT SPECIFICATION

(11) **EP 4 045 921 B1**
(45) Date of publication and mention of the grant of the patent: **27.11.2024**
(21) Application number: 19797177.3
(22) Date of filing: 15.10.2019
(51) Int. Cl.: G01R 19/155

(54) **AN APPARATUS FOR INDICATING A STATUS OF AN ELECTRICAL CABLE**
GERÄT ZUR ANZEIGE DES STATUS EINES ELEKTRISCHEN KABELS
APPAREIL POUR L'INDICATION D'UN ÉTAT D'UN CÂBLE ÉLECTRIQUE

(43) Date of publication of application: 24.08.2022
(73) Proprietor: Volvo Construction Equipment AB, 631 85 Eskilstuna (SE)
(72) Inventor: CZERW, Michal, 51-230 Wroclaw (PL); ZAMORSKI, Piotr, 50-231 Wroclaw (PL); CZURA, Lukasz, 53-139 Wroclaw (PL); WAWRZYNIAK, Monika, 55002 Kamieniec Wroclawski (PL)
(74) Representative: Valea AB
(86) International application number: PCT/EP2019/077846
(87) International publication number: WO 2021/073720

(56) References cited:
- WO-A1-2018/021410
- US-A1- 2008 198 277

## Description

### TECHNICAL FIELD

The invention relates to an apparatus for indicating a status of an electrical cable. The invention also relates to a power system and a vehicle, a working machine or a vessel. The invention further relates to a method for indicating a status of an electrical cable, a computer program, and a computer readable medium.

The invention can be applied in heavy-duty vehicles, such as trucks, buses and construction equipment. The invention can also be applied in working machines and vessels. Although the invention will be described with respect to a bus, the invention is not restricted to this particular vehicle, but may also be used in other vehicles such as trucks, trailers, wheel loaders, excavators, passenger cars, etc.

### BACKGROUND

Due to an ongoing electrification within the transport and construction equipment sectors, electric drive systems including e.g. batteries, electric motors/generators and various types of converters are becoming increasingly common in various types of vehicles, including heavy-duty vehicles. In order to gain sufficient power output for large machines, such electric drive systems are usually configured for delivering power at voltage levels which are higher in comparison to traditional vehicles, in which the batteries may deliver power at voltage levels of 12-24V DC. In electrified heavy-duty vehicles such as construction equipment or buses, a voltage level of 600V may typically be needed, and in electrically operated cars, a voltage level of 300V is common. Such voltage levels can cause electric shock and are therefore considered hazardous for humans.

Thus, there is a need for safety procedures and fail-safe systems to deal with the risks associated with such voltage levels on-board vehicles and construction equipment. Such procedures and systems have to some extent already been implemented, for example detailed commissioning / decommissioning procedures and technical measures such as high-voltage interlock loops (HVIL), insulation resistance monitoring devices, and insulated 600V circuits. However, personnel needing to deal with hybrid or electric machines are often stressed to work with potentially hazardous power systems and touch parts that were energised minutes ago.

US20170010311 discloses a device for indicating that an electrical connector used in mining equipment is safe to disconnect. The device comprises a driving circuit which is parasitically coupled to a conductor of the electrical connector, and an indicator providing a visual indication as to whether the conductor is energised or not.

WO 2018/021410 A1 discloses a device that is to be attached to a cable and that comprises a LED that lights up when the voltage measured on the cable exceeds a certain value.

However, electric drive systems used in automotive applications and construction machines include a lot of cabling, and the connectors may not be immediately possible to identify in case of e.g. an accident. In view of this, it would be desirable to provide reliable means for indicating whether an electrical cable is safe to touch or not.

### DEFINITIONS

An electrical cable is herein to be understood as an assembly of one or more elongated insulated conductors or wires for transmission of electrical power. The electrical cable may include one or more shielding layer(s). The term "cable" is herein used in short for "electrical cable". The electrical cable may include e.g. two insulated conductors or wires configured to be at different voltage levels. For a direct current (DC) power source, the electrical cable may include one ground conductor or wire, and one positive or negative conductor or wire. For an alternating current (AC) power source, the electrical cable may either include one neutral conductor or wire and one phase conductor or wire, or three phase conductors or wires.

By "hazardous voltage" is herein intended a voltage level that may be considered harmful for humans. Voltage levels above 30V for DC voltage and above 12V for AC voltage are considered hazardous voltages.

### SUMMARY

A primary object of the invention is to provide an apparatus and a method for reliably indicating a status of an electrical cable that can be used in a power system of a heavy-duty vehicle, i.e. primarily for indicating whether the electrical cable is reliably safe to touch for humans, or not. In particular, it is an object to provide such an apparatus and method which can more reliably indicate whether the electrical cable is potentially hazardous to touch in situations such as accidents.

According to a first aspect of the invention, at least the primary object is achieved by an apparatus for indicating a status of an electrical cable according to claim 1.

The status of the electrical cable may be e.g. "safe for humans" or "harmful for humans", based on the measured voltage.

The apparatus is thus configured to emit light via the light-emitting indicators in dependence on the measured voltage of the electrical cable.

Since the apparatus according to the invention is adapted to be powered by a power source other than the electrical cable, the light-emitting indicators may emit light regardless of whether the electrical cable is energised or not. The characteristics of the emitted light, e.g. colour, i.e. wavelength, flashing pattern and intensity, depend on the measured voltage. In other words, the apparatus will reliably indicate a status of the electrical cable not only when the electrical cable is energised, but also when the cable is not energised. Thus, the invention enables distinction between a first case when the cable is safe to touch, and a second case when the apparatus itself is not working, since in the first case, light is emitted from the light-emitting indicators, and in the second case, no light is emitted. This is in contrast to solutions in which the light-emitting indicators are powered via a parasitical coupling to the cable.

In order to be adapted to be powered by a power source other than the electrical cable, the apparatus may comprise connection means for electrical connection of a power source other than the electrical cable for powering the apparatus. Thus, the apparatus, including the voltage measuring means and the control means, or an electronic control unit comprising those means, and the light-emitting indicators, may be powered by the power source. The power source may be a battery, such as an internal battery for mounting within a housing of the apparatus, or an external battery which may be connected to the apparatus. The power source may be a Li-lon battery, e.g. a 15 V Li-Ion battery. The power source may also be an external vehicle battery, e.g. a 12 V external vehicle battery. The power source may also be a hazardous voltage battery to which the electrical cable is connected, such as a 600 V DC battery, in which case a DC/DC power converter is needed to reduce the voltage level. If the battery is the hazardous voltage battery, a DC link may be provided for connection to components of the apparatus.

The voltage measuring means may be at least one voltage sensor, such as a voltage probe, for example a voltage probe in the form of a bipolar sensor.

The light-emitting indicators may comprise at least one light-emitting diode, or preferably at least two light-emitting diodes (LEDs) configured to emit light of different colour. The light-emitting indicators may also comprise indicator(s) including fluorescent material that can be energised and thereby emit light, and/or any other indicator(s) which is/are able to emit light when energised.

The light-emitting indicators are visibly attached to the electrical cable, meaning that they are attached to the cable in such a way that the light emitted therefrom is clearly visible upon inspection of the cable. The light-emitting indicators may e.g. be mounted on a cable harness comprising the electrical cable whose voltage is measured, or they may be mounted inside or moulded into a transparent hose of the cable.

The light-emitting indicators are configured so that light may be emitted along a length of the electrical cable. In contrast to solutions in which energisation of a connector is indicated, the status of the cable may thus be reliably indicated along a length of the cable, i.e. along a longitudinal central axis of the cable. This is particularly advantageous for long cables. It is also valuable in case of accidents, when loose ends of energised and potentially harmful cables may be present, and a connector may not be immediately identifiable. Since the light-emitting indicators will emit light indicating the status of the cable along its length, it is immediately apparent whether the cable is safe to touch or not.

The light-emitting indicators may comprise a plurality of light-emitting indicators configured to be mounted along the electrical cable. Thus, reliable emission of light along the length of the cable is ensured. The plurality of light-emitting indicators may e.g. be in the form of light-emitting diodes (LEDs). For example, LED tape may be used, or LEDs may be arranged inside a transparent jacket of the electrical cable or of a cable harness including the electrical cable. Light may thereby be emitted along a length of the cable. The plurality of light-emitting indicators may all be of the same type, or they may be of different types. For example, the plurality of light emitting indicators may comprise a first set of light-emitting indicators configured for emitting light of a first colour, i.e. of a first wavelength, and a second set of light-emitting indicators configured for emitting light of a second colour, i.e. of a second wavelength. The control means may herein be configured to control either the first set or the second set to emit light, in dependence on the measured voltage. For example, this may be the case if LEDs are used. LEDs provide a reliable and energy efficient means for emission of light.

The voltage measuring means may comprise at least two voltage probes for measuring a voltage between at least two conductors of the electrical cable, the control means being configured to control the emission of light from the light-emitting indicators based on the measured voltage between the conductors. The two conductors of the electrical cable may e.g. be a positive conductor and a ground conductor, or a neutral conductor and a phase conductor. Thus, it can be indicated whether it is associated with danger to simultaneously touch the conductors in e.g. isolated ground circuits commonly used in vehicle power systems.

The voltage measuring means may be configured to contact a conductor of the electrical cable at a non-shielded portion of the conductor, and the apparatus may further comprise a shield configured to electromagnetically shield the non-shielded portion of the conductor when the apparatus is attached to the electrical cable. A reliable voltage measurement may thereby be achieved without risking problems originating from electromagnetic interference (EMI) with surrounding electrical equipment.

The apparatus may comprise at least one electronic control unit configured to control the voltage measuring means and the emission of light from the light-emitting indicators.

To this end, the electronic control unit may be configured for measuring a voltage of the electrical cable, e.g. a voltage between conductors of the cable, and for controlling the light-emitting indicators based on the measured voltage of the electrical cable. Thus, in this case, the electronic control unit comprises the control means for controlling emission of light and the voltage measuring means.

The apparatus may comprise at least two such electronic control units configured to work in redundancy. This ensures functionality also if one of the electronic control units is damaged.

The control means may be configured to control at least one of a colour, an intensity and a flashing pattern of light emitted from the light-emitting indicators based on the measured voltage of the electrical cable. Preferably, at least a colour, i.e. a wavelength, and a flashing pattern are controlled, e.g. by using a steady green light to signal that the measured voltage is below a predefinable threshold level, and a blinking red light to signal that the measured voltage is above a predefinable threshold level. This ensures that colour blind people are able to distinguish between safe and potentially hazardous voltage levels. Moreover, the intensity and/or a flashing frequency may be adjusted in dependence on the measured voltage, e.g. by increasing the intensity and/or the flashing frequency with increasing voltage.

The control means may be configured to determine the status of the electrical cable based on the measured voltage thereof to one of at least a first status and a second status, wherein the first status is associated with a measured voltage below a predefinable threshold level or within a first predefinable range, and the second status is associated with a measured voltage above the predefinable threshold level or within a second predefinable range, wherein the control means is further configured to control the emission of light based on the determined status. Hereby, it becomes easy to distinguish between statuses, e.g. "harmful" and "safe", associated with different measured voltage levels.

More than two statuses may be predefinable, wherein each status is associated with a predefinable voltage range, allowing distinction between more than two voltage ranges.

According to an example, if e.g. LEDs are used as light-emitting indicators, a first set of light-emitting indicators, configured to emit light of a first colour, may e.g. be controlled to an OFF state if the voltage is below the threshold level, and to an ON state if the voltage is above the threshold level, while a second set of light-emitting indicators, configured to emit light of a second colour, may be controlled to an ON state if the voltage is below the threshold level, and to an OFF state if the voltage is above the threshold level. The ON state may herein be understood to also include various flashing patterns, in addition to steady light emission.

The threshold level may preferably be set to a voltage level considered to be safe for humans, i.e. a voltage level which is below a hazardous voltage that may lead to electrical shock. The threshold level may be set to different voltage levels depending on whether the electrical cable is used for direct current (DC) voltage or alternating current (AC) voltage power transmission. For example, a threshold level of 30V for DC voltage and a threshold level of 12V for AC voltage may be set, which levels are usually considered as safe voltage levels in wet conditions. Likewise, the first predefinable range may be set to e.g. 0-12 V for AC voltage and to 0-30 V for DC voltage.

Each one of the at least first and second statuses may be associated with the emission of light of at least one of a predefinable distinguishing colour, a predefinable distinguishing intensity and a predefinable distinguishing flashing pattern. In other words, for each one of the at least first and second statuses, the control means may be configured to control the light-emitting indicators to emit light of at least one of a predefinable colour, a predefinable intensity and a predefinable flashing pattern. It will thereby be easy to distinguish between the different statuses. Preferably, each one of the at least first and second statuses are associated with the emission of light of at least a predefinable distinguishing colour and a predefinable distinguishing flashing pattern in order to facilitate distinguishing between the statuses.

The apparatus may further comprise current measuring means for measuring an electric current of the electrical cable. This enables current measurement for diagnostic purposes. The current measuring means may e.g. be in the form of a Rogowski coil, a shunt based current sensor, or a clamp-on current probe.

The apparatus may further comprise a signal interface for communicating data to and/or from the apparatus, such as data relating to the status of the electrical cable. This allows communication and merging with e.g. on-board electromobility electronic control units such as other safety systems etc. The signal interface may be configured for communicating via a Controller Area Network (CAN) bus.

According to a second aspect of the invention, at least the primary object is also achieved by a cable assembly comprising an electrical cable and an apparatus according to the first aspect, wherein the light-emitting indicators are attached to the electrical cable and wherein the voltage measuring means is configured for measuring a voltage of the electrical cable.

Advantages and effects provided by the cable assembly are largely analogous to the advantages and effects provided by the first aspect of the invention. It shall also be noted that each embodiment of the second aspect of the invention is applicable with each embodiment of the other aspects of the invention and vice versa.

According to a third aspect of the invention, at least the primary object is also achieved by an energy storage system comprising at least one power source and at least one cable assembly according to the second aspect connected to the at least one power source. The energy storage system may e.g. form part of an electric drive system, such as an electric propulsion system, of a vehicle, a vessel or a working machine.

The power source may be an AC power source, e.g. a generator connected to e.g. an internal combustion engine or similar, or a DC power source, including e.g. batteries, capacitors, supercapacitors, and/or fuel cells. The energy storage system may further comprise a power converter/inverter assembly. Various electric systems and devices, such as an electric traction motor, a lighting system, an audio system, a hydraulic pump, or other auxiliary systems, may be connected to the energy storage system and receive AC or DC power output therefrom.

Advantages and effects provided by the energy storage system are largely analogous to the advantages and effects provided by the first aspect of the invention. It shall also be noted that each embodiment of the third aspect of the invention is applicable with each embodiment of the other aspects of the invention and vice versa.

According to a fourth aspect of the invention, at least the primary object is also achieved by a vehicle or a working machine or a vessel comprising an apparatus according to the first aspect and/or a cable assembly according to the second aspect and/or an energy storage system according to the third aspect. The vehicle or vessel or working machine may be fully electrified or it may be driven by a hybrid drive system, comprising both an electric motor and a combustion engine.

Advantages and effects provided by the vehicle or vessel or working machine are largely analogous to the advantages and effects provided by the first aspect of the invention. It shall also be noted that each embodiment of the fourth aspect of the invention is applicable with each embodiment of the other aspects of the invention and vice versa. According to a fifth aspect of the invention, at least the primary object is also achieved by a method for indicating a status of an electrical cable according to the independent method claim 11.

Advantages and effects provided by the method are largely analogous to the advantages and effects provided by the first aspect of the invention. It shall also be noted that each embodiment of the fifth aspect of the invention is applicable with each embodiment of the other aspects of the invention and vice versa.

Controlling the emission of light from the light-emitting indicators may comprise controlling at least one of a colour, an intensity and a flashing pattern of light emitted from the light-emitting indicators based on the measured voltage of the electrical cable.

Controlling the emission of light from the light-emitting indicators may comprise:
- determining the status of the electrical cable based on the measured voltage thereof to one of at least a first status and a second status, wherein the first status is associated with a measured voltage below a predefinable threshold level or within a first predefinable range, and the second status is associated with a measured voltage above the predefinable threshold level or within a second predefinable range,
- controlling the emission of light from the light-emitting indicators based on the determined status.

According to a sixth aspect of the invention, at least one of the above defined objects is achieved by a computer program comprising program code means for performing the steps of the method according to the fifth aspect when said computer program is run on a device according to one of the first to fourth aspects.

According to a seventh aspect of the invention, at least one of the above defined objects is achieved by a computer readable medium carrying a computer program comprising program code means for performing the steps of the method according to the fifth aspect when said computer program is run on a device according to one of the first to fourth aspects.

Further advantages and advantageous features of the invention are disclosed in the following description and in the dependent claims.

### BRIEF DESCRIPTION OF THE DRAWINGS

With reference to the appended drawings, below follows a more detailed description of embodiments of the invention cited as examples.

In the drawings:
- Fig. 1: is a perspective view of a vehicle according to an embodiment of the invention,
- Fig. 2: is a perspective view of a power system including an apparatus according to an embodiment of the invention,
- Fig. 3: is a perspective view of an apparatus according to an embodiment of the invention,
- Fig. 4: is a schematic view of the apparatus according to an embodiment of the invention, and
- Fig. 5: is a flow chart illustrating a method according to an embodiment of the invention.

The drawings show diagrammatic exemplifying embodiments of the present invention and are thus not necessarily drawn to scale. It shall be understood that the embodiments shown and described are exemplifying and that the invention is not limited to these embodiments. It shall also be noted that some details in the drawings may be exaggerated in order to better describe and illustrate the invention. Like reference characters refer to like elements throughout the description, unless expressed otherwise.

### DETAILED DESCRIPTION OF EXAMPLE EMBODIMENTS OF THE INVENTION

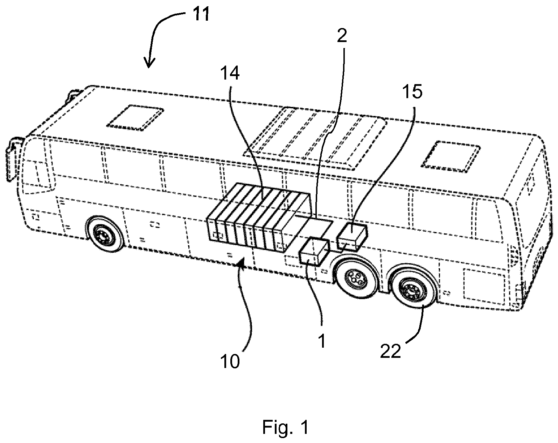

Fig. 1 schematically depicts a motor vehicle 11 in the form of an electrically operated bus. The bus is an example of a vehicle in which an apparatus 1 according to embodiments of the invention may be applied. The vehicle 11 comprises a schematically illustrated energy storage system 10 connected to an electric motor (not shown) for propelling drive wheels 22 of the vehicle 11. The energy storage system 10 includes a battery 14 comprising a plurality of battery units, an electrical cable 2 connecting the battery 14 to a power converter/inverter assembly 15, and an apparatus 1 for indicating a status of the electrical cable 2. The energy storage system 10 forms part of an electric propulsion system of the vehicle 11.

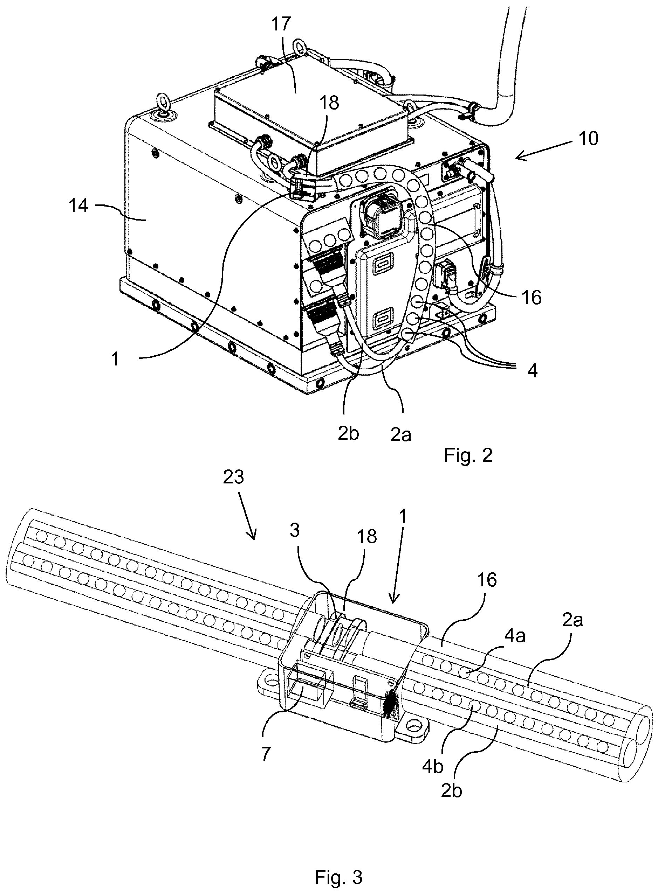

A 600 V battery 14 and a pre-charge device 17 for use in a vehicle or working machine is shown in fig. 2. The pre-charge device 17 is connected to the battery 14 by means of two electrical cables 2a, 2b, which are herein bound together in a cable harness 16. An apparatus 1 for indicating a status of the electrical cables 2a, 2b is furthermore provided, i.e. for indicating whether any one of the cables 2a, 2b is energised by a potentially hazardous voltage level or not. The apparatus 1 has a housing 18 mounted around the cables 2a, 2b and attached to a casing of the battery 14. The apparatus 1 includes a plurality of light-emitting indicators 4 that are visibly attached to the cable harness 16. The light-emitting indicators 4 are configured to emit light indicating the status of the electrical cables 2a, 2b based on a measured voltage level thereof as will be further explained below.

Fig. 3 shows a cable assembly 23 including an apparatus 1 according to an embodiment of the invention and two electrical cables 2a, 2b, bound together in a cable harness 16. The cables 2a, 2b may in this case be connected to e.g. a 600 V DC power source of a vehicle, in which case one of the cables 2a may be at a voltage level of +600 V, and the other cable 2b is ground, i.e. at a 0 V voltage level. In the shown embodiment, the cable harness 16 comprises a transparent hose inside which the cables 2a, 2b extend. The apparatus 1 includes a housing 18, mounted around the cables 2a, 2b, which housing 18 is configured to be attached to e.g. a battery casing by means of fastening elements (not shown), similarly to what is shown in fig. 1. The apparatus 1 further comprises voltage measuring means 3 for continuously measuring a voltage level between the respective electrical cables 2a, 2b. The voltage measuring means 3 is controlled by an electronic control unit 7. In this case, the voltage measuring means 3 comprises two voltage probes, such that a voltage level between the cables 2a, 2b can be determined, thereby determining if it would be hazardous to touch the cables.

Two sets of light-emitting indicators 4a, 4b are provided, each set of light-emitting indicators 4a, 4b being mounted on and along the respective electrical cable 2a, 2b. In the shown embodiment, the sets of light-emitting indicators 4a, 4b are provided as LED strips attached to the electrical cables 2a, 2b. The electronic control unit 7 is adapted for controlling emission of light from the two sets of light-emitting indicators 4a, 4b based on the measured voltage level between the electrical cables 2a, 2b. Thus, the emission of light from the two sets of light-emitting indicators 4a, 4b is controlled based on the same measured voltage level between the cables 2a, 2b.

The apparatus 1, including the voltage measuring means 3, the electronic control unit 7 and the light-emitting indicators 4a, 4b, is configured to be powered by a power source other than the electrical cables 2a, 2b. In other words, the apparatus 1 is not parasitically coupled to the cables 2a, 2b. Instead, another power source (not shown in fig. 3) is provided. For this purpose, the apparatus 1 comprises connection means (not shown) for connecting a power source such as an external or internal battery (not shown).

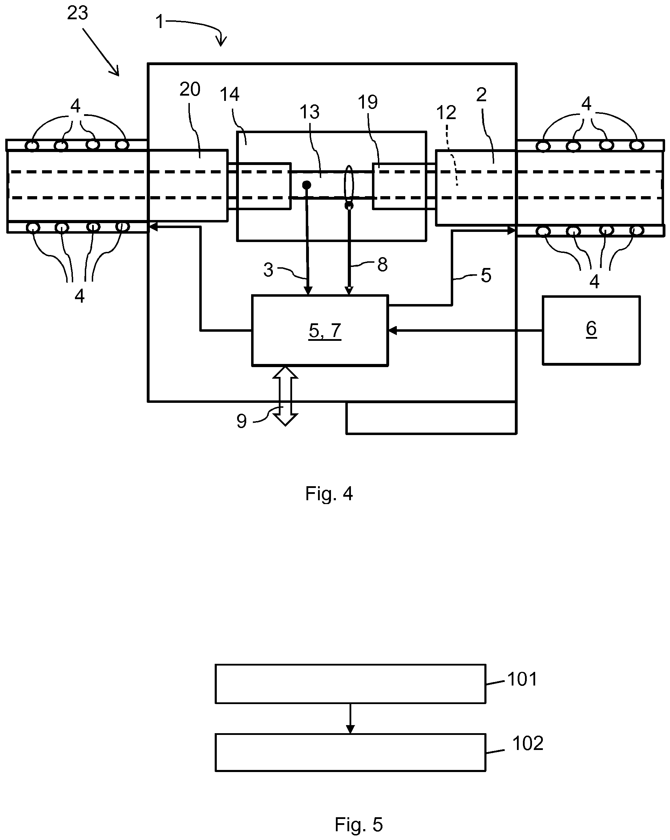

Reference is now also made to fig. 4, schematically showing an apparatus 1 for indicating the status of an electrical cable 2 in further detail. For simplicity, only one elongated conductor 12 of the electrical cable 2 is shown in fig. 4, although it is to be understood that this cable 2 typically includes a set of at least two insulated conductors, which may be in the form of separate cables such as shown in fig. 3. The cable 2 may e.g. include a ground conductor and a "live" conductor for a DC power source, or a phase conductor and a neutral conductor for an AC power source, or alternatively three phase conductors for an AC power source. Around the elongated conductor 12, a shielding layer 19, protecting against electromagnetic interference (EMI), and an electrically insulating layer 20, are provided. The voltage measuring means 3, comprising a voltage probe, is in contact with a non-shielded portion 13 of the conductor 12. A separate shield 14, enclosing the non-shielded portion 13, is provided. The shield 14 is configured to electromagnetically shield the non-shielded portion 13 of the conductor 12 when the apparatus is attached to the electrical cable 2. A current measuring means 8 in the form of a Rogowski coil is positioned around the non-shielded portion 13 of the conductor 12. The voltage measuring means 3 and the current measuring means 8 are both connected to and controlled by an electronic control unit 7. The set of light-emitting indicators 4 are also connected to the electronic control unit 7 such that a control means 5 for controlling the emission of light from the light-emitting indicators 4 based on the voltage of the electrical cable 2, i.e. a measured voltage between the conductors 12 forming part of the electrical cable 2, is provided. The electronic control unit 7, and thereby also the voltage measuring means 3, the control means 5, the current measuring means 8 and the light-emitting indicators 4, are powered by a power source 6 in the form of a battery. The power source 6 may be placed inside a housing of the apparatus 1 or provided separately. A signal interface 9 for communicating data to and/or from the electronic control unit 7 is also provided.

Two electronic control units 7 configured to work in redundancy may be provided, such that the fail-safe arrangement is achieved.

The control means 5, i.e. the electronic control unit 7, is configured to control a colour and/or an intensity and/or a flashing pattern of light emitted from the light-emitting indicators 4 based on the voltage of the electrical cable 2, i.e. the measured voltage between the conductors 12.

The electronic control unit 7 is in the shown embodiment configured to determine the status of the electrical cable 2 based on the measured voltage between the conductors 12 thereof (of which only one is shown in fig. 4) to one of a first status and a second status. The first status, which may be labelled "safe", is associated with a measured voltage below a predefinable threshold level. For example, a threshold level of 30 V for DC voltage and a threshold level of 12 V for AC voltage may be set, which levels are usually considered as safe voltage levels in wet conditions. The second status, which may be labelled "hazardous", is associated with a measured voltage above the predefinable threshold level. The electronic control unit 7 is configured to control the emission of light from the light-emitting indicators 4 based on the determined status. The first status is associated with the emission of light of a first distinguishing colour, such as green, and a first distinguishing flashing pattern, such as steady, i.e. non-flashing. The second status is associated with the emission of light of a second distinguishing colour, such as red, and a second distinguishing flashing pattern, such as blinking. The intensity of the light, and/or the blinking frequency, may also be set to vary with the measured voltage. For example, the intensity and/or blinking frequency may be set to increase with increasing voltage.

A method according to an embodiment of the invention is illustrated in fig. 5. An apparatus 1 attached to at least one electrical cable 2 as described above is used in the method.

In a first step 101, a voltage of the electrical cable 2 is continuously measured by means of the voltage measuring means 3.

In a second step 102, the emission of light from the light-emitting indicators 4, 4a, 4b is controlled based on the measured voltage of the electrical cable 2 determined in the first step 101.

Power for measuring the voltage in the first step 101 and for controlling the emission of light in the second step 102 is obtained from a power source 6 other than the electrical cable 2.

According to an example, the electrical cable 2 as illustrated in fig. 4 forms part of an energy storage system 10 such as illustrated in fig. 2, including both a pre-charge device 17 and a hazardous voltage battery 14. The energy storage system 10 is connected to a power converter/inverter assembly 15 as shown in fig. 1 configured for providing electrical power to drive an electric machine. The apparatus 1 is used for continuously monitoring the status of the electrical cable 2. At a first point in time, a pre-charge device switch is turned on, and a hazardous voltage of 600 V, which is well above a preset threshold level of 30 V, is applied. The cable 2 is thus energised. The voltage measuring means 3 measures a voltage above the threshold level and determines that the status of the cable 2 is the second status, i.e. "hazardous". The control means 5 controls the light-emitting indicators 4 to emit red, blinking light. At a second later point in time, the pre-charge device switch is switched off to disconnect the battery 14, and the measured voltage starts to decrease. However, due to discharging of capacitors forming part of the power converter/inverter assembly 15, the measured voltage of the cable 2 may still be above the threshold level of 30 V for a certain time period, and the light-emitting indicators 4 continue to emit red, blinking light. As soon as the measured voltage decreases below the threshold level, the control means 5 controls the light-emitting indicators 4 to emit green, steady light.

The control functionality of the example embodiments may be implemented using existing computer processors, or by a special purpose computer processor for an appropriate system, incorporated for this or another purpose, or by a hardwire system. Embodiments within the scope of the present disclosure include program products comprising machine-readable medium for carrying or having machine-executable instructions or data structures stored thereon. Such machine-readable media can be any available media that can be accessed by a general purpose or special purpose computer or other machine with a processor. By way of example, such machine-readable media can comprise RAM, ROM, EPROM, EEPROM, CD-ROM or other optical disk storage, magnetic disk storage or other magnetic storage devices, or any other medium which can be used to carry or store desired program code in the form of machine-executable instructions or data structures and which can be accessed by a general purpose or special purpose computer or other machine with a processor. When information is transferred or provided over a network or another communications connection (either hardwired, wireless, or a combination of hardwired or wireless) to a machine, the machine properly views the connection as a machine-readable medium. Thus, any such connection is properly termed a machine-readable medium. Combinations of the above are also included within the scope of machine-readable media. Machine-executable instructions include, for example, instructions and data which cause a general purpose computer, special purpose computer, or special purpose processing machines to perform a certain function or group of functions.

It is to be understood that the present invention is not limited to the embodiments described above and illustrated in the drawings; rather, the skilled person will recognize that many changes and modifications may be made within the scope of the appended claims.

## Claims

1. An apparatus (1) for indicating a status of an electrical cable (2, 2a, 2b), the apparatus (1) being configured to be attached to the electrical cable (2, 2a, 2b), the apparatus (1) comprising:
- voltage measuring means (3) for continuously measuring a voltage of the electrical cable (2, 2a, 2b),
- light-emitting indicators (4, 4a, 4b) configured to be visibly attached to the electrical cable (2, 2a, 2b),
- control means (5) for controlling emission of light from the light-emitting indicators (4, 4a, 4b) based on the measured voltage of the electrical cable (2, 2a, 2b),
wherein the apparatus (1) is adapted to be powered by a power source (6) other than the electrical cable (2, 2a, 2b),
wherein the light-emitting indicators (4, 4a, 4b) are configured so that light may be emitted along a length of the electrical cable (2, 2a, 2b).

2. The apparatus according to claim 1, wherein the light-emitting indicators (4, 4a, 4b) comprise a plurality of light-emitting indicators configured to be mounted along the electrical cable (2, 2a, 2b).

3. The apparatus according to claim 1 or 2, wherein the voltage measuring means (3) comprises at least two voltage probes for measuring a voltage between at least two conductors (12) of the electrical cable (2, 2a, 2b), the control means (5) being configured to control the emission of light from the light-emitting indicators (4, 4a, 4b) based on the measured voltage between the conductors (12).

4. The apparatus according to any one of the preceding claims, wherein the voltage measuring means (3) is configured to contact a conductor (12) of the electrical cable (2) at a non-shielded portion (13) of the conductor (12), and wherein the apparatus (1) further comprises a shield (14) configured to electromagnetically shield the non-shielded portion (13) of the conductor (12) when the apparatus (1) is attached to the electrical cable (2).

5. The apparatus according to any one of the preceding claims, wherein the apparatus comprises at least one electronic control unit (7) configured to control the voltage measuring means (3) and the emission of light from the at least one light-emitting indicator (4, 4a, 4b), preferably wherein the apparatus (1) comprises at least two such electronic control units configured to work in redundancy.

6. The apparatus according to any one of the preceding claims, wherein the control means (5) is configured to control at least one of a colour, an intensity and a flashing pattern of light emitted from the light-emitting indicators (4, 4a, 4b) based on the measured voltage of the electrical cable (2, 2a, 2b).

7. The apparatus according to any one of the preceding claims, wherein the control means (5) is configured to determine the status of the electrical cable (2, 2a, 2b) based on the measured voltage thereof to one of at least a first status and a second status, wherein the first status is associated with a measured voltage below a predefinable threshold level or within a first predefinable range, and the second status is associated with a measured voltage above the predefinable threshold level or within a second predefinable range, and wherein the control means (5) is further configured to control the emission of light based on the determined status, preferably wherein each one of the at least first and second statuses is associated with the emission of light of at least one of a predefinable distinguishing colour, a predefinable distinguishing intensity and a predefinable distinguishing flashing pattern.

8. A cable assembly (23) comprising an electrical cable (2, 2a, 2b) and an apparatus (1) according to any one of the preceding claims, wherein the light-emitting indicators (4, 4a, 4b) are attached to the electrical cable (2, 2a, 2b) and wherein the voltage measuring means (3) is configured for measuring a voltage of the electrical cable (2a, 2b).

9. An energy storage system (10) comprising at least one power source and at least one cable assembly according to claim 8 connected to the at least one power source.

10. A vehicle (11) or a working machine or a vessel comprising an apparatus (1) according to any one of claims 1-7, or a cable assembly (23) according to claim 8, or an energy storage system (10) according to claim 9.

11. A method for indicating a status of an electrical cable (2, 2a, 2b), the method comprising:
- continuously measuring (101) a voltage of the electrical cable (2, 2a, 2b),
- controlling (102) emission of light from light-emitting indicators (4, 4a, 4b) based on the measured voltage of the electrical cable (2, 2a, 2b), the light-emitting indicators (4, 4a, 4b) being visibly attached to the electrical cable (2, 2a, 2b);
wherein a power for measuring the voltage and for controlling the emission of light is obtained from a power source (6) other than the electrical cable (2, 2a, 2b),
wherein
the light-emitting indicators (4, 4a, 4b) are configured so that light may be emitted along a length of the electrical cable (2, 2a, 2b).

12. The method according to claim 11, wherein controlling the emission of light from the light-emitting indicators (4, 4a, 4b) comprises controlling at least one of a colour, an intensity and a flashing pattern of light emitted from the light-emitting indicators (4, 4a, 4b) based on the measured voltage of the electrical cable (2, 2a, 2b).

13. The method according to claim 11 or 12, wherein controlling the emission of light from the light-emitting indicators (4, 4a, 4b) comprises:
- determining the status of the electrical cable (2, 2a, 2b) based on the measured voltage thereof to one of at least a first status and a second status, wherein the first status is associated with a measured voltage below a predefinable threshold level or within a first predefinable range, and the second status is associated with a measured voltage above the predefinable threshold level or within a second predefinable range,
- controlling the emission of light from the light-emitting indicators (4, 4a, 4b) based on the determined status.

14. A computer program comprising program code means for performing the steps of any one of claims 11-13 when said computer program is run on a device according to any of claims 1-10.

15. A computer readable medium carrying a computer program comprising program code means for performing the steps of any one of claims 11-13 when said computer program is run on a device according to any of claims 1-10.

## Patentansprüche

1. Vorrichtung (1) zum Anzeigen eines Status eines elektrischen Kabels (2, 2a, 2b), wobei die Vorrichtung (1) konfiguriert ist, um an dem elektrischen Kabel (2, 2a, 2b) angebracht zu werden, wobei die Vorrichtung (1) umfasst:
- ein Spannungsmessmittel (3) zum kontinuierlichen Messen einer Spannung des elektrischen Kabels (2, 2a, 2b),
- lichtemittierende Anzeigeeinrichtungen (4, 4a, 4b), die konfiguriert sind, um an dem elektrischen Kabel (2, 2a, 2b) sichtbar angebracht zu werden,
- Steuermittel (5) zum Steuern von Lichtemission der lichtemittierenden Anzeigeeinrichtungen (4, 4a, 4b) basierend auf der gemessenen Spannung des elektrischen Kabels (2, 2a, 2b),
wobei die Vorrichtung (1) angepasst ist, um durch eine andere Stromquelle (6) als das elektrische Kabel (2, 2a, 2b) mit Strom versorgt zu werden,
wobei die lichtemittierenden Anzeigeeinrichtungen (4, 4a, 4b) konfiguriert sind, sodass Licht entlang einer Länge des elektrischen Kabels (2, 2a, 2b) emittiert werden kann.

2. Vorrichtung nach Anspruch 1, wobei die lichtemittierenden Anzeigeeinrichtungen (4, 4a, 4b) eine Vielzahl von lichtemittierenden Anzeigeeinrichtungen umfassen, die konfiguriert sind, um entlang des Elektrokabels (2, 2a, 2b) montiert zu werden.

3. Vorrichtung nach Anspruch 1 oder 2, wobei das Spannungsmessmittel (3) mindestens zwei Spannungssonden zum Messen einer Spannung zwischen mindestens zwei Leitern (12) des elektrischen Kabels (2, 2a, 2b) umfasst, wobei das Steuermittel (5) konfiguriert ist, um die Lichtemission von den lichtemittierenden Anzeigeeinrichtungen (4, 4a, 4b) basierend auf der gemessenen Spannung zwischen den Leitern (12) zu steuern.

4. Vorrichtung nach einem der vorstehenden Ansprüche, wobei das Spannungsmessmittel (3) konfiguriert ist, um einen Leiter (12) des elektrischen Kabels (2) an einem nicht abgeschirmten Abschnitt (13) des Leiters (12) zu berühren, und wobei die Vorrichtung (1) ferner eine Abschirmung (14) umfasst, die konfiguriert ist, um den nicht abgeschirmten Abschnitt (13) des Leiters (12) elektromagnetisch abzuschirmen, wenn die Vorrichtung (1) an das elektrische Kabel (2) angeschlossen ist.

5. Vorrichtung nach einem der vorstehenden Ansprüche, wobei die Vorrichtung mindestens eine elektronische Steuereinheit (7) umfasst, die konfiguriert ist, um das Spannungsmessmittel (3) und die Lichtemission von der mindestens einen lichtemittierenden Anzeigeeinrichtung (4, 4a, 4b) zu steuern, vorzugsweise wobei die Vorrichtung (1) mindestens zwei derartige elektronische Steuereinheiten umfasst, die konfiguriert sind, um redundant zu arbeiten.

6. Vorrichtung nach einem der vorstehenden Ansprüche, wobei das Steuermittel (5) konfiguriert ist, um mindestens eines von einer Farbe, einer Intensität und einem Blinkmuster des von den lichtemittierenden Anzeigeeinrichtungen (4, 4a, 4b) emittierten Lichts basierend auf der gemessenen Spannung des Elektrokabels (2, 2a, 2b) zu steuern.

7. Vorrichtung nach einem der vorstehenden Ansprüche, wobei das Steuermittel (5) konfiguriert ist, um den Status des elektrischen Kabels (2, 2a, 2b) basierend auf der gemessenen Spannung davon auf mindestens einen ersten Status und einen zweiten Status zu bestimmen, wobei der erste Status mit einer gemessenen Spannung unterhalb eines vordefinierbaren Schwellenpegels oder innerhalb eines ersten vordefinierbaren Bereichs verknüpft ist und der zweite Status mit einer gemessenen Spannung oberhalb des vordefinierbaren Schwellenpegels oder innerhalb eines zweiten vordefinierbaren Bereichs verknüpft ist, und wobei das Steuermittel (5) ferner konfiguriert ist, um die Lichtemission basierend auf dem bestimmten Status zu steuern, vorzugsweise wobei jeder des mindestens ersten und des zweiten Status mit der Lichtemission mit mindestens einem von einer vordefinierbaren Unterscheidungsfarbe, einer vordefinierbaren Unterscheidungsintensität und einem vordefinierbaren Unterscheidungsblinkmuster verknüpft ist.

8. Kabelanordnung (23), umfassend ein elektrisches Kabel (2, 2a, 2b) und eine Vorrichtung (1) nach einem der vorstehenden Ansprüche, wobei die lichtemittierenden Anzeigeeinrichtungen (4, 4a, 4b) an dem elektrischen Kabel (2, 2a, 2b) angebracht sind und wobei das Spannungsmessmittel (3) zum Messen einer Spannung des elektrischen Kabels (2a, 2b) konfiguriert ist.

9. Energiespeichersystem (10), umfassend mindestens eine Stromquelle und mindestens eine Kabelanordnung nach Anspruch 8, die mit der mindestens einen Stromquelle verbunden ist.

10. Fahrzeug (11) oder Arbeitsmaschine oder Wasserfahrzeug, umfassend eine Vorrichtung (1) nach einem der Ansprüche 1 bis 7 oder eine Kabelanordnung (23) nach Anspruch 8 oder ein Energiespeichersystem (10) nach Anspruch 9.

11. Verfahren zum Anzeigen eines Status eines elektrischen Kabels (2, 2a, 2b), wobei das Verfahren umfasst:
- kontinuierliches Messen (101) einer Spannung des elektrischen Kabels (2, 2a, 2b),
- Steuern (102) der Lichtemission von lichtemittierenden Anzeigeeinrichtungen (4, 4a, 4b) basierend auf der gemessenen Spannung des elektrischen Kabels (2, 2a, 2b), wobei die lichtemittierenden Anzeigeeinrichtungen (4, 4a, 4b) an dem elektrischen Kabel (2, 2a, 2b) sichtbar angebracht sind,
wobei ein Strom zum Messen der Spannung und zum Steuern der Lichtemission von einer anderen Stromquelle (6) als dem Elektrokabel (2, 2a, 2b) erhalten wird,
wobei die lichtemittierenden Anzeigeeinrichtungen (4, 4a, 4b) konfiguriert sind, sodass Licht entlang einer Länge des elektrischen Kabels (2, 2a, 2b) emittiert werden kann.

12. Verfahren nach Anspruch 11, wobei das Steuern der Lichtemission von den lichtemittierenden Anzeigeeinrichtungen (4, 4a, 4b) das Steuern von mindestens einem von einer Farbe, einer Intensität und einem Blinkmuster des von den lichtemittierenden Anzeigeeinrichtungen (4, 4a, 4b) emittierten Lichts basierend auf der gemessenen Spannung des elektrischen Kabels (2, 2a, 2b) umfasst.

13. Verfahren nach Anspruch 11 oder 12, wobei das Steuern der Lichtemission von den lichtemittierenden Anzeigen (4, 4a, 4b) umfasst:
- Bestimmen des Status des elektrischen Kabels (2, 2a, 2b) basierend auf der gemessenen Spannung davon auf mindestens einem von einem ersten Status und einem zweiten Status, wobei der erste Status mit einer gemessenen Spannung unterhalb eines vordefinierbaren Schwellenpegels oder innerhalb eines ersten vordefinierbaren Bereichs verknüpft ist und der zweite Status mit einer gemessenen Spannung oberhalb des vordefinierbaren Schwellenpegels oder innerhalb eines zweiten vordefinierbaren Bereichs verknüpft ist,
- Steuern der Lichtemission der lichtemittierenden Anzeigeeinrichtungen (4, 4a, 4b) basierend auf dem bestimmten Status.

14. Computerprogramm, umfassend Programmcodemittel zum Durchführen der Schritte nach einem der Ansprüche 11 bis 13, wenn das Computerprogramm auf einer Vorrichtung nach einem der Ansprüche 1 bis 10 ausgeführt wird.

15. Computerlesbares Medium, das ein Computerprogramm trägt, umfassend Programmcodemittel zum Durchführen der Schritte nach einem der Ansprüche 11 bis 13, wenn das Computerprogramm auf einer Vorrichtung nach einem der Ansprüche 1 bis 10 ausgeführt wird.

## Revendications

1. Appareil (1) permettant d'indiquer un état d'un câble électrique (2, 2a, 2b), l'appareil (1) étant conçu pour être fixé au câble électrique (2, 2a, 2b),
l'appareil (1) comprenant :
- un moyen de mesure de tension (3) permettant de mesurer en continu une tension du câble électrique (2, 2a, 2b),
- des indicateurs électroluminescents (4, 4a, 4b) conçus pour être fixés de manière visible au câble électrique (2, 2a, 2b),
- un moyen de commande (5) permettant de commander l'émission de lumière provenant des indicateurs électroluminescents (4, 4a, 4b) en fonction de la tension mesurée du câble électrique (2, 2a, 2b),
dans lequel l'appareil (1) est adapté pour être alimenté par une source d'alimentation (6) autre que le câble électrique (2, 2a, 2b), dans lequel les indicateurs électroluminescents (4, 4a, 4b) sont conçus de sorte que la lumière puisse être émise le long d'une longueur du câble électrique (2, 2a, 2b).

2. Appareil selon la revendication 1, dans lequel les indicateurs électroluminescents (4, 4a, 4b) comprennent une pluralité d'indicateurs électroluminescents conçus pour être montés le long du câble électrique (2, 2a, 2b).

3. Appareil selon la revendication 1 ou 2, dans lequel le moyen de mesure de tension (3) comprend au moins deux sondes de tension permettant de mesurer une tension entre au moins deux conducteurs (12) du câble électrique (2, 2a, 2b), le moyen de commande (5) étant conçu pour commander l'émission de lumière provenant des indicateurs électroluminescents (4, 4a, 4b) en fonction de la tension mesurée entre les conducteurs (12).

4. Appareil selon l'une quelconque des revendications précédentes, dans lequel le moyen de mesure de tension (3) est conçu pour entrer en contact avec un conducteur (12) du câble électrique (2) au niveau d'une partie non blindée (13) du conducteur (12), et dans lequel l'appareil (1) comprend en outre un blindage (14) conçu pour blinder électromagnétiquement la partie non blindée (13) du conducteur (12) lorsque l'appareil (1) est fixé au câble électrique (2).

5. Appareil selon l'une quelconque des revendications précédentes, dans lequel l'appareil comprend au moins une unité de commande électronique (7) conçue pour commander le moyen de mesure de tension (3) et l'émission de lumière provenant de l'au moins un indicateur électroluminescent (4, 4a, 4b), de préférence dans lequel l'appareil (1) comprend au moins deux telles unités de commande électronique conçues pour fonctionner en redondance.

6. Appareil selon l'une quelconque des revendications précédentes, dans lequel le moyen de commande (5) est conçu pour commander au moins l'un parmi une couleur, une intensité et un motif de clignotement d'une lumière émise provenant des indicateurs électroluminescents (4, 4a, 4b) en fonction de la tension mesurée du câble électrique (2, 2a, 2b).

7. Appareil selon l'une quelconque des revendications précédentes, dans lequel le moyen de commande (5) est conçu pour déterminer l'état du câble électrique (2, 2a, 2b) en fonction de la tension mesurée de celui-ci à l'un d'au moins un premier état et un second état, dans lequel le premier état est associé à une tension mesurée inférieure à un niveau de seuil prédéfinissable ou au sein d'une première plage prédéfinissable, et le second état est associé à une tension mesurée supérieure au niveau de seuil prédéfinissable ou au sein d'une seconde plage prédéfinissable, et dans lequel le moyen de commande (5) est en outre conçu pour commander l'émission de lumière en fonction de l'état déterminé, de préférence dans lequel chacun des au moins premier et second états est associé à l'émission de lumière d'au moins l'un parmi une couleur distinctive prédéfinissable, une intensité distinctive prédéfinissable et un motif de clignotement distinctif prédéfinissable.

8. Ensemble câble (23) comprenant un câble électrique (2, 2a, 2b) et un appareil (1) selon l'une quelconque des revendications précédentes, dans lequel les indicateurs électroluminescents (4, 4a, 4b) sont fixés au câble électrique (2, 2a, 2b) et dans lequel le moyen de mesure de tension (3) est conçu pour mesurer une tension du câble électrique (2a, 2b).

9. Système de stockage d'énergie (10) comprenant au moins une source d'alimentation et au moins un ensemble câble selon la revendication 8 connecté à l'au moins une source d'alimentation.

10. Véhicule (11) ou machine de travail ou navire comprenant un appareil (1) selon l'une quelconque des revendications 1 à 7, ou ensemble câble (23) selon la revendication 8, ou système de stockage d'énergie (10) selon la revendication 9.

11. Procédé permettant d'indiquer un état d'un câble électrique (2, 2a, 2b), le procédé comprenant :
- la mesure en continu (101) d'une tension du câble électrique (2, 2a, 2b),
- la commande (102) de l'émission de lumière provenant d'indicateurs électroluminescents (4, 4a, 4b) en fonction de la tension mesurée du câble électrique (2, 2a, 2b), les indicateurs électroluminescents (4, 4a, 4b) étant fixés de manière visible au câble électrique (2, 2a, 2b) ;
dans lequel une alimentation permettant de mesurer la tension et de commander l'émission de lumière est obtenue d'une source d'alimentation (6) autre que le câble électrique (2, 2a, 2b), dans lequel les indicateurs électroluminescents (4, 4a, 4b) sont conçus de sorte que la lumière puisse être émise le long d'une longueur du câble électrique (2, 2a, 2b).

12. Procédé selon la revendication 11, dans lequel la commande de l'émission de lumière provenant des indicateurs électroluminescents (4, 4a, 4b) comprend la commande d'au moins l'un parmi une couleur, une intensité et un motif de clignotement d'une lumière émise provenant des indicateurs électroluminescents (4, 4a, 4b) en fonction de la tension mesurée du câble électrique (2, 2a, 2b).

13. Procédé selon la revendication 11 ou 12, dans lequel la commande de l'émission de lumière provenant des indicateurs électroluminescents (4, 4a, 4b) comprend :
- la détermination de l'état du câble électrique (2, 2a, 2b) en fonction de la tension mesurée de celui-ci à l'un d'au moins un premier état et un second état, dans lequel le premier état est associé à une tension mesurée inférieure à un niveau de seuil prédéfinissable ou au sein d'une première plage prédéfinissable, et le second état est associé à une tension mesurée supérieure au niveau de seuil prédéfinissable ou au sein d'une seconde plage prédéfinissable,
- la commande de l'émission de lumière provenant des indicateurs électroluminescents (4, 4a, 4b) en fonction de l'état déterminé.

14. Programme d'ordinateur comprenant des moyens de code de programme permettant de réaliser les étapes selon l'une quelconque des revendications 11 à 13 lorsque ledit programme d'ordinateur est exécuté sur un dispositif selon l'une quelconque des revendications 1 à 10.

15. Support lisible par ordinateur portant un programme d'ordinateur comprenant des moyens de code de programme permettant de réaliser les étapes selon l'une quelconque des revendications 11 à 13 lorsque ledit programme d'ordinateur est exécuté sur un dispositif selon l'une quelconque des revendications 1 à 10.
